(19) **Europäisches Patentamt / European Patent Office / Office européen des brevets**

(11) **EP 4 391 369 B1**

(12) **EUROPEAN PATENT SPECIFICATION**

(45) Date of publication and mention
of the grant of the patent:
**06.08.2025  Bulletin 2025/32**

(21) Application number: **23217934.1**

(22) Date of filing: **19.12.2023**

(51) International Patent Classification (IPC):
**H03D 7/14** *(2006.01)*    **H03D 7/16** *(2006.01)*

(52) Cooperative Patent Classification (CPC):
**H03D 7/1441; H03D 7/1491; H03D 7/165; H03D 7/166**

(54) **ELECTRIC CIRCUIT PROVIDING MIXING AND GAINING FUNCTIONS FOR A RF RECEIVER FRONT-END AND RF RECEIVER FRONT-END**

ELEKTRISCHE SCHALTUNG ZUR BEREITSTELLUNG VON MISCH- UND VERSTÄRKUNGSSFUNKTIONEN FÜR EIN HF-EMPFÄNGER-FRONTEND UND HF-EMPFÄNGER-FRONTEND

CIRCUIT ÉLECTRIQUE FOURNISSANT DES FONCTIONS DE MÉLANGE ET DE GAIN POUR UN FRONTAL DE RÉCEPTEUR RF ET FRONTAL DE RÉCEPTEUR RF

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **23.12.2022  EP 22216554**
**18.12.2023  US 202318543264**

(43) Date of publication of application:
**26.06.2024  Bulletin 2024/26**

(73) Proprietor: **CSEM Centre Suisse d'Electronique et de**
**Microtechnique SA  - Recherche et Développement**
**2002 Neuchâtel (CH)**

(72) Inventor: **Manetakis, Konstantinos**
**2000 Neuchâtel (CH)**

(74) Representative: **P&TS SA (AG, Ltd.)**
**Avenue J.-J. Rousseau 4**
**P.O. Box 2848**
**2001 Neuchâtel (CH)**

(56) References cited:
**US-B2- 10 181 868**

- **CHEN HONGPENG ET AL: "A Wideband Dual-path Reconfigurable Receiver Front-end in 180 nm CMOS", 2020 IEEE INTERNATIONAL CONFERENCE ON SEMICONDUCTOR ELECTRONICS (ICSE), IEEE, 28 July 2020 (2020-07-28), pages 69 - 72, XP033810786, DOI: 10.1109/ICSE49846.2020.9166867**
- **HAIWEI ZHANG ET AL: "Direct conversion receiver with high conversion gain and wide tuning range in 0.18 um CMOS", 2014 ASIA-PACIFIC MICROWAVE CONFERENCE, IEICE, 4 November 2014 (2014-11-04), pages 1037 - 1039, XP032750629**

## Description

### Technical domain

The present invention concerns an electric circuit providing mixing and gaining functions for a RF receiver front-end and a RF receiver front-end.

### Related art

RF receivers are arranged to receive RF signals, i.e. signals having an RF frequency. In this context, an RF frequency is a frequency between 3 kHz and 300 GHz, in particular between 300 MHz and 100 GHz.

Examples for receiver circuits of the related art are known from patent document US 10 181 868 B2 and articles "A Wideband Dual-path Reconfigurable Receiver Front-end in 180 nm CMOS" by Chen Hongpeng at al. (IEEE INTERNATIONAL CONFERENCE ON SEMICONDUCTOR ELECTRONICS (ICSE), 2020-07-28, pages 69-72) and "Direct conversion receiver with high conversion gain and wide tuning range in 0.18 um CMOS" by Haiwei Zhang et al. (ASIA-PACIFIC MICROWAVE CONFERENCE, (IEICE), 2014-11-04, pages 1037-1039).

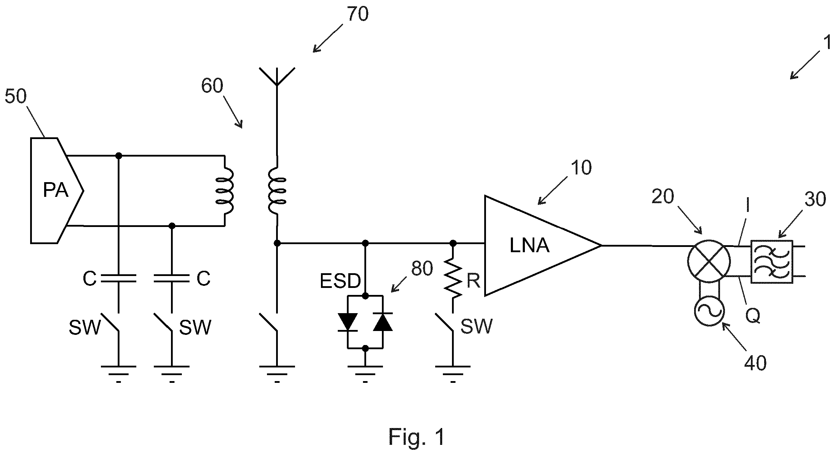

A known RF receiver is illustrated in Figure 1. It comprises an antenna 70, followed in general by a balun 60. The antenna 70 in the example of Figure 1 is shared with a power amplifier (PA) 50 of an RF transmitter. In the example of Figure 1, the PA has a differential output. The antenna interface and sharing with the transmitter can be designed so that to enable large PA output powers. Each output of the PA can be connected to the ground by a capacitor C in series with a switch SW. The received RF signal is then amplified by a Low Noise Amplifier (LNA) 10. The LNA 10 can be preceded by an electrostatic discharge device (ESD) 80 and/or by a resistor R connected to the ground by a switch SW that acts as an attenuator.

The frequency of the amplified RF signal then is translated to a lower frequency, e.g. to an intermediate frequency (IF) which is lower than an RF frequency, or to a baseband frequency, by a mixer 20, so that the mixed signal can be processed further. Therefore, the mixer 20 in a RF receiver is a down-converting mixer.

A mixer 20 is in general connected to an oscillator (LO) 40 arranged for generating a carrier signal, having a carrier frequency.

The RF signal received at the antenna 70 is in general modulated and comprises an in-phase component and a quadrature-phase component. Therefore, the mixer 20 comprises in general a I path (I) and a Q path (Q), for processing the in-phase component and the quadrature-phase component of the received RF signal respectively.

An RF receiver front-end 1 comprises in general the LNA 10 and the mixer 20. The mixer 20 is in general followed by a (base-band) filter 30. The base-band filtered signal is then in general converted to a digital signal by an analog-to-digital converter (ADC), not illustrated in Figure 1.

The mixer 20 can be active or passive. Active mixers have a power gain, which is in general provided by using active device(s) or transconductance stage(s). One advantage of active mixers is that their power gain reduces the contribution of the noise of the subsequent blocks. However, their linearity can be poor. The well-known Gilbert mixer is a typical example of an active mixer.

Passive mixers usually comprise a commutating device (e.g. a switch or a diode) that has no bias current. Passive mixers have zero power gain.

Passive mixers can be current-mode mixers respectively voltage-mode mixers. In current-mode mixers, commutating devices are used for switching currents. In voltage-mode mixers, commutating devices are used for switching voltages.

Passive mixers have become the solution of choice in recent times primarily for their low flicker noise, high linearity (mostly related to the absence of a transconductance stage), low power consumption and speed. However, the use of those passive mixers needs large gain further down in the receiver chain.

Moreover, they are not well adapted to low power applications, i.e. to applications consuming power lower than few mW, which require no amplification after the mixer. In fact, in those applications, the mixer is active so that no gain is necessary after the mixer.

Concerning the whole RF front-end, common issues of existing RF receiver front-ends comprise the used silicon area, the power dissipation, the linearity, the noise and/or the sensitivity.

### Short disclosure of the invention

An aim of the present invention is the provision of an electric circuit for a RF receiver front-end, which allows to solve or mitigate at least one of the issues of existing electric circuits.

Another aim of the present invention is the provision of an electric circuit for a RF receiver front-end, which is adapted to low power applications.

Another aim of the present invention is the provision of an electric circuit for a RF receiver front-end, which has a relatively low noise.

Another aim of the present invention is the provision of an electric circuit for a RF receiver front-end, which has a good linearity.

Another aim of the present invention is the provision of an electric circuit for a RF receiver front-end, which is alternative to the known electric circuits.

Another aim of the present invention is the provision of a RF receiver front-end, which allows to solve or mitigate at least one of the RF receiver front-end's mentioned issues.

According to the invention, these aims are attained by the object of the attached claims, and especially by an electric circuit for a front-end of a RF receiver according to claim 1, and by a RF receiver front-end according to claim 7.

The electric circuit providing mixing and gaining functions for a RF receiver front-end according to the invention comprises an I path and a Q path, wherein each of the I path and the Q path comprises:

- a switch,
- an input capacitor having a first terminal connected to the switch and a second terminal connected to an input of an operational amplifier,
- the operational amplifier,
- a feedback capacitor having a first terminal connected to the input of the operational amplifier and a second terminal connected to the output of the operational amplifier,

the electric circuit comprising:

- a bias resistor so as to DC-bias the operational amplifier input,
- a local oscillator connected to the mixer and arranged to generate a carrier signal having a carrier frequency, a gate of the switch being coupled to the LO,
- a command module arranged to sequentially close each switch during a mixer's averaging window, so that an incoming signal having a frequency close to the carrier frequency, i.e. a frequency belonging to a mixer bandwidth, results in a non-zero down-converted signal across the input capacitor, this down-converted signal being then amplified by the operational amplifier so that an amplified down-converted signal appears at the output of the operational amplifier.

According to the invention, the mixer comprises a resistor ($R_p$) between each input capacitor and the corresponding input of the operational amplifier, so as to introduce a pole in the frequency translated transfer function. This pole helps to simplify the filtering done in the analog baseband circuitry that follows the mixer.

In one embodiment, the mixer bandwidth is given by the formula:

$$BW = 2 \; \frac{1}{2\pi \cdot 4 (R_S + R_{SW}) C_1},$$

wherein

$R_S$ is the resistance of a source resistor connected to the switch,
$R_{SW}$ is the resistance of each switch once it is closed
$C_1$ is the capacitance of each input capacitor.

In this context, the expression "sequentially close" indicates that only a switch can be closed at a time. In one preferred embodiment, the mixer's averaging window is equal to the carrier period $T_{LO}$ divided by the total number of the switches of the I and Q paths. For example, if each of the I and Q path comprises one switch, then there are two switches: the mixer's averaging window is equal to a half of the carrier period ($T_{LO}/2$). Therefore, a first switch will be closed during the first half of the carrier period (the second switch being open), and the second switch will be closed during the second half of the carrier period (the first switch being open), those two halves of the carrier period being not overlapping.

The electric circuit providing mixing and gaining functions according to the invention comprises a mixer which is an averaging mixer, i.e. it is arranged for averaging an incoming signal. It does not commutate or sample, it averages the incoming signal. In other words, the mixing operation is performed by averaging on the input capacitors.

Signals close to the carrier frequency and its harmonics are in-sync with the carrier signal. They thus move slowly through the mixer's averaging window resulting in non-zero output. In other words, if the incoming signal is close in frequency to the carrier signal, then the averaging results in a finite output (the signal looks nearly the same every time the carrier looks at it, so the average is non-zero).

Signals far away (i.e. not close) from the carrier frequency and its harmonics move fast through the mixer's averaging window resulting in zero output. In other words, if the signal is far away in frequency from the carrier signal, the averaging results in zero output.

The electric circuit according to the invention provides a gain. In other words, the electric circuit according to the invention provides simultaneously mixing and gaining functions. Since it provides a gain, then it reduces the overall power by relaxing the need for large gain further down in the receiver chain.

Therefore, the electric circuit according to the invention is well adapted to low power applications.

Moreover, the electric circuit according to the invention has a relatively low noise and a good linearity.

In the electric circuit according to the invention, a down-converted baseband (or IF) signal appears across input capacitors ($C_1$). An amplified down-converted baseband (or IF) signal appears at the output of the operational amplifier. The voltage gain from the input capacitors ($C_1$) to the output of the operational amplifier is equal to $C_1/C_2$, wherein $C_2$ is the feedback capacitor.

In one embodiment, the operational amplifier is a fully differential operational amplifier, the switch is a first switch, the input capacitor is a first input capacitor, the input is a first input, the output is a first output, the mixer's averaging window is a first mixer's averaging window and each of the I path and the Q path comprises:

- a second switch,
- a second input capacitor between the second switch and a second input of the differential operational amplifier,
- a second feedback capacitor between the second input and a second output of the operational amplifier.

In this embodiment, the command module is arranged to sequentially close each switch during a second mixer's averaging window, so that said incoming signal results in a non-zero down-converted signal across the input capacitors, this down-converted signal being then amplified by the differential operational amplifier so that an amplified down-converted signal appears at the first and second outputs of the differential operational amplifier.

In this embodiment, each of the I and Q path comprises two switches, then there are four switches: the mixer's averaging window is equal to a quarter of the carrier period ($T_{LO}/4$). Therefore, a first switch will be closed during the first quarter of the carrier period (the other three switches being open), a second switch will be closed during the second quarter of the carrier period (the other three switches being open), a third switch will be closed during the third quarter of the carrier period (the other three switches being open) and a fourth switch will be closed during the fourth quarter of the carrier period (the other three switches being open), those four quarters of the carrier period being not overlapping.

In one embodiment, the feedback capacitor(s) is(are) variable feedback capacitor(s), so as to have a variable gain. This helps to reduce power dissipation in the analog baseband.

In one embodiment, by controlling the variable feedback capacitor, the gain from RF to the frequency translated I/Q outputs can be set to 18dB, 12dB or 6dB.

In one embodiment, the bias resistor is connected to the input(s) of the operational amplifier, so as to DC-bias the operational amplifier inputs. In one embodiment, the bias resistor is large, i.e. its resistance is larger than 25 K$\Omega$.

In one embodiment, the bias resistor is a feedback resistor(s) is(are)across each feedback capacitor(s). This allows to introduce a zero (at zero frequency) and a pole (at $1/(R_B C_2)$) in the baseband (or IF) signal transfer function. In one embodiment, the feedback resistor is large, i.e. its resistance is larger than 250 K$\Omega$.

In one embodiment, the feedback resistor(s) is(are) selected so that a pole in a frequency translated signal transfer function is at least 5 times lower in frequency than the wanted frequency translated signal for the gain settings.

In one embodiment, a gate of each switch is AC-coupled to at least one of the LOs. The switch is not necessarily directly coupled to the LOs. For example, a control block could be present between the LOs and the gates, so as to generate the phases.

In one embodiment, the switches have a low or zero onresistance, and are arranged to turn off well (good isolation). A practical implementation uses MOS devices as switches.

In one embodiment, the electric circuit comprises at least one digital-to-analog converter (DAC) for controlling the dc-level at the gates.

The present invention also concerns a RF receiver front-end, comprising:

- an LNA,
- the electric circuit according to the invention, connected to an output of the LNA.

In one embodiment, the LNA comprises a current-reuse common-source stage, the current-reuse common-source stage comprising:

- a p-type transistor,
- a n-type transistor sharing a variable current with the p-type transistor,

- a gain resistor ($R_G$) between a gate and a drain of the p-type transistor,
- a first capacitor connected to the gate of the p-type transistor,
- a second capacitor connected to the gate of the n-type transistor,
- a p-type bias voltage control module, comprising a first switch and a p-type bias voltage transistor, the first switch being between a source terminal of the p-type bias voltage transistor and a source terminal of the p-type transistor, a gate and a drain of the p-type bias voltage transistor being connected to the gate and the drain of the p-type transistor,
- a n-type bias voltage control module, comprising a second switch and a n-type bias voltage transistor, the second switch being between a source terminal of the n-type bias voltage transistor and a source terminal of the n-type transistor, a gate and a drain of the n-type bias voltage transistor being connected to a gate and a drain of the n-type transistor.

The LNA of this embodiment comprises also a command module arranged to control the first switch and the second switch, so as to operate the current-reuse common-source stage under constant current density, so as to obtain a constant linearity.

Therefore, the RF front-end according to this embodiment presents many advantages: first, the LNA is devoid of inductors. Since the electric circuit is also devoid of inductors, the RF receiver front-end silicon area is drastically reduced since the RF receiver front-end is an inductor-less RF receiver front-end.

Second, the LNA is arranged to operate at constant current density to optimize linearity.

Third, bias current control of the LNA allows to tradeoff power dissipation for sensitivity. In other words, it is possible to maintain a known sensitivity performance, while reducing power dissipation.

In one embodiment, the LNA comprises at least two p-type bias voltage control modules and/or at least two n-type bias voltage control modules.

In one embodiment, the current-reuse common-source stage comprises a gain control module, wherein the gain control module comprises at least one gain control resistor in series with a third switch, the series of the gain control resistor with the third switch being in parallel to the gain resistor ($R_G$).

In one embodiment, the p-type transistor and the n-type transistor are operated in a moderate inversion, so as to optimize the third order input intercept point (IIP3) of the LNA.

In one embodiment, the current-reuse common-source stage is a first current-reuse common-source stage, the LNA comprising a second current-reuse common-source stage in series with the first current-reuse common-source stage. This allows to drive the mixer with an elevated impedance (a few hundred Ohms), which in general is beneficial for both the noise and the linearity performance of the mixer.

In one embodiment, the front-end comprises a baseband (or IF) amplifier, connected to an output of the electric circuit and arranged so as to provide a baseband gain depending on the LNA gain and on the mixer gain, e.g. so as to have a given total gain of the front-end.

In one embodiment, the baseband (or IF) amplifier is a baseband (or IF) filter.

In one embodiment, the baseband (or IF) filter is arranged to be configured as a two pole filter, as a single pole filter or it can be bypassed, so as to trade-off its sharpness for power dissipation. In this embodiment, the baseband (or IF) filter has then a reconfigurable topology that saves power in the analog baseband (or IF) at the expense of the carrier to interference ratio (C/I) and/or alias attenuation.

In one embodiment, the two pole filter is a polynomial filter, e.g. a Tow-Thomas filter.

In one embodiment, the baseband (or IF) filter is a first stage baseband (or IF) filter, the front-end comprising a second stage baseband (or IF) filter in series with the first stage baseband (or IF) filter.

In one embodiment, the first stage baseband (or IF) filter has a quality factor lower than the second stage baseband (or IF) filter.

**Short description of the drawings**

Exemplar embodiments of the invention are disclosed in the description and illustrated by the drawings in which:

Figure 1 illustrates a known RF receiver.

Figure 2 illustrates the operation basics of a part of the electric circuit according to the invention.

Figure 3 illustrates the differential gain from the harmonic n to the baseband (or IF) as a function of the harmonic number n of one embodiment of the part of the electric circuit of Figure 2.

Figure 4 illustrates another embodiment of the operation basics of a part of the electric circuit according to the invention, in particular for computing its bandwidth and/or its noise.

Figure 5 illustrates another embodiment of the operation basics of a part of the electric circuit according to the invention, in particular for computing its RF impedance.

Figure 6 illustrates a schematic representation of an embodiment of a part of the electric circuit according to the invention, in particular for computing its linearity.

Figure 7 illustrates an embodiment of the electric circuit according to a comparative example not covered by the invention.

Figure 8 illustrates another embodiment of the electric circuit according to a comparative example not covered by the invention.

Figure 9 illustrates another embodiment of the electric circuit according to the invention.

Figure 10 illustrates an embodiment of how to drive the switches of the electric circuit according to certain embodiments.

Figure 11 illustrates an embodiment of the LNA of the RF receiver front-end according to the invention.

Figure 12 illustrates an embodiment of a part of a stage of the LNA of the RF receiver front-end according to the invention Figure 13 illustrates the drain current ($I_D$) of an embodiment of the LNA MOS device of the RF receiver front-end according to the invention, as a function of the gate-source voltage ($V_{GS}$) of this LNA MOS device, for showing a general continuous model for a LNA MOS device.

Figure 14 illustrates the first-order transconductance ($g_1$), the second-order transconductance ($g_2$) and the third-order transconductance ($g_3$) of an embodiment of the LNA MOS device of the RF receiver front-end according to the invention, as a function of the gate-source voltage ($V_{GS}$) of this LNA MOS device.

Figure 15 illustrates the IIP3, the second order input intercept point (IIP2) and the drain current ($I_D$) of an embodiment of the LNA MOS device of the RF receiver front-end according to the invention, as a function of the gate-source voltage ($V_{GS}$) of this LNA MOS device.

Figure 16 illustrates an embodiment of the baseband (or IF) filter of the RF receiver front-end according to one embodiment of the invention.

Figure 17A illustrates a first possible configuration of the baseband (or IF) filter of Figure 16.

Figure 17B illustrates a second possible configuration of the baseband (or IF) filter of Figure 16.

Figure 18 illustrates another embodiment of the baseband (or IF) filter of the RF receiver front-end according to one embodiment of the invention.

**Examples of embodiments of the present invention**

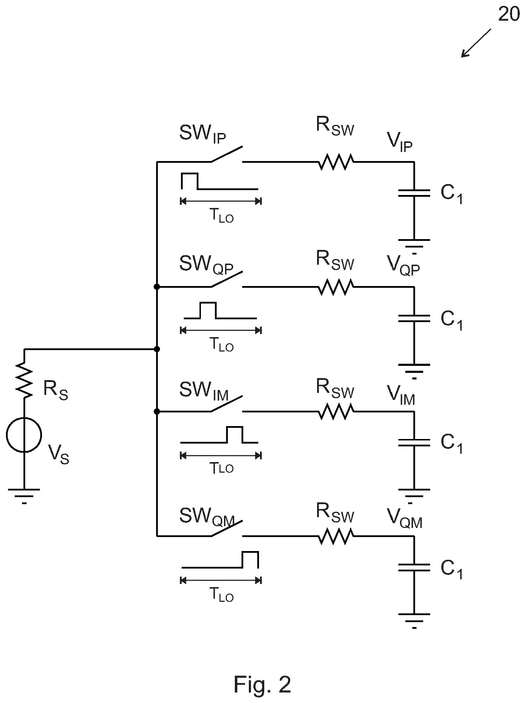

Figure 2 illustrates the operation basics of a part of the electric circuit 20 according to the invention (the operational amplifier, the feedback capacitor and the command module are not represented).
The electric circuit 20 of Figure 2 operates by RC filtering (averaging) the incoming RF carrier (which has been schematically indicated by a voltage source $V_S$ followed by a resistor $R_S$) over a time window.
In one embodiment, this time window is equal to $T_{LO}/2$, wherein $T_{LO}$ is the period of the signal generated by a LO (not-illustrated) connected to the electric circuit 20.
In the illustrated embodiment, wherein the electric circuit 20 comprises a fully differential operational amplifier (not illustrated in Figure 2), this time window is equal to $T_{LO}/4$.
In the embodiment of Figure 2, the electric circuit 20 comprises two paths for the in-phase component of the received signal (the first and the third starting from the top of Figure 2), and two paths for the quadrature-phase component of the received signal (the second and the fourth starting from the top of Figure 2).
In the embodiment of Figure 2, the I path switch $SW_{IP}$ will be closed for a first 1/4 of a LO period of the LO connected to the mixer, the Q path switch $SW_{QP}$ will be closed for a second 1/4 of the LO period, the I path bar switch $SW_{IM}$ will be closed for a third 1/4 of a LO period, the Q path bar switch $SW_{QM}$ will be closed for a fourth ¼ of the LO period, and that those four 1/4 LO periods do not overlap. Any other order of closing of those four switches could be used, as long as the four 1/4 LO periods do not overlap.

Once closed, each switch of Figure 2 presents a resistance $R_{SW}$, which has been illustrated in series to each switch, for representing the fact that it is not ideal.

Signals close to the LO frequency and its harmonics are in-sync with the LO. They thus move slowly through the averaging window resulting in non-zero output.

Signals far away from the LO frequency and its harmonics move fast through the averaging window resulting in zero output.

Non-zero outputs of the electric circuit 20 comprise the four voltages $V_{IP}$, $V_{QP}$, $V_{IM}$, $V_{QM}$ across capacitors $C_1$, which are the input capacitors of the electric circuit according to the invention, arranged to be connected to an operational amplifier.

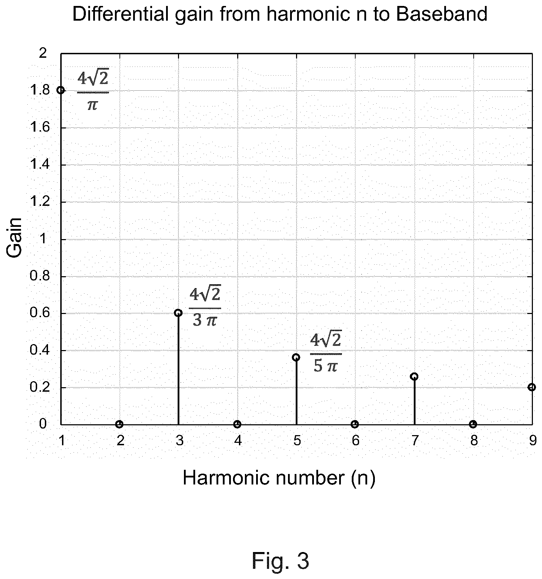

Figure 3 illustrates the differential gain from the harmonic n to the baseband (or IF) as a function of the harmonic number n of one embodiment of the part of the electric circuit 20 of Figure 2.

Due to the "averaging" operation, the conversion voltage gain from harmonic n to baseband (or IF) can be estimated by:

$$G_n = \left.\frac{V_{IP}}{V_s}\right|_n = \frac{2}{\pi} \int_{\varphi_o}^{\varphi_o + \frac{\pi}{2}} \sin(n\varphi)\, d\varphi \tag{1}$$

wherein $\varphi_0$ is a phase chosen to maximize the integral of formula (1), in order to obtain the peak value of the down-converted signal.

When looking at the output differentially, the voltage gains from even harmonics cancel out.

Therefore, there is a non-zero differential voltage gain only from the odd-harmonics with values as shown in the Figure 3.

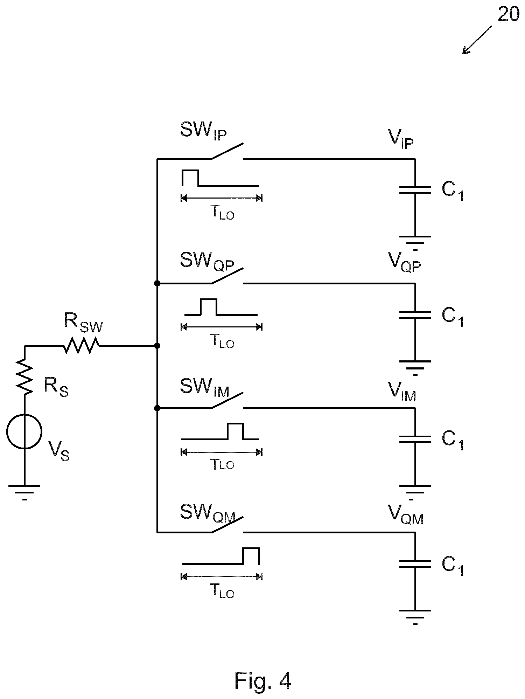

Figure 4 illustrates another embodiment of the operation basics of a part of the electric circuit according to the invention, in particular for computing its bandwidth and/or its noise, wherein the switch resistor $R_{SW}$ has been pulled out.

Each capacitor $C_1$ is charged successively by $V_S$ via the total resistor $R_S + R_{SW}$.

In the embodiment of Figure 4, each capacitor $C_1$ "sees" $V_S$ during only one-fourth of the LO period, therefore the effective charging resistance is $4 \cdot (R_S + R_{SW})$.

It is therefore expected a 3 dB baseband bandwidth BW (-3 dB to -3 dB) that is given by:

$$\mathrm{BW} \approx 2\, \frac{1}{2\pi \cdot 4(R_S + R_{SW})C_1} \tag{2}$$

As the bandwidth BW of formula (2) depends on the source resistor $R_S$, in one embodiment this resistor should be kept far beyond the baseband (or IF) frequency operation range.

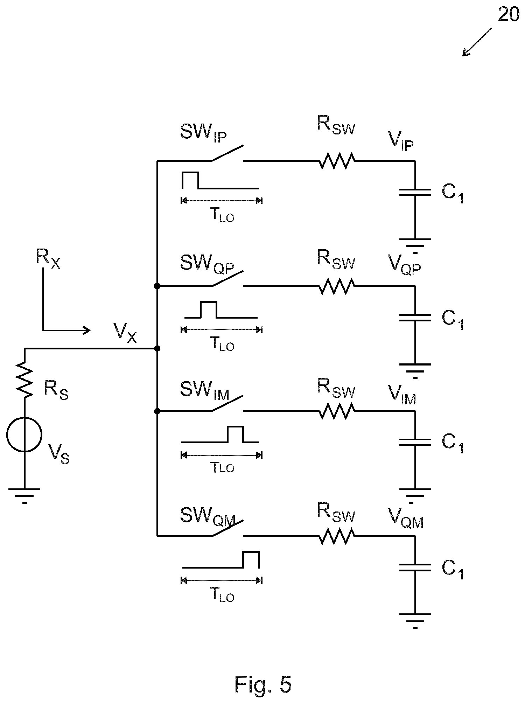

Figure 5 illustrates another embodiment of the operation basics of a part of the electric circuit according to the invention, in particular for computing its RF impendence $R_x$, and then S11.

Voltage $V_x$ at harmonic n consists of two components.

The first component $V_{x|1}$ is due to $V_S$ and is given by the following formula:

$$V_x|_1 = V_s \frac{R_{SW}}{R_{SW} + R_S} \tag{3}$$

The second component $V_x|_2$ is due to the up-conversion of the baseband (or IF) signal stored on the capacitors $C_1$ back to RF via the switches and is given by the following formula, wherein n is the harmonic number:

$$V_x|_2 = \left( V_S \frac{2\sqrt{2}}{n\pi} \right)\left( \frac{R_S}{R_{SW} + R_S} \right)\left( \frac{2\sqrt{2}}{n\pi} \right) \tag{4}$$

The input impedance $R_x$ at LO harmonic n can then be estimated by the following formula for harmonics (odd n):

$$R_x = \frac{V_x}{V_S - V_x} R_S = \frac{R_{SW} + R_S \left( \frac{2\sqrt{2}}{n\pi} \right)^2}{1 - \left( \frac{2\sqrt{2}}{n\pi} \right)^2} \tag{5}$$

Furthermore, for n = 2 the input impedance $R_x$ is

$$R_x = \frac{R_{SW} + R_S \frac{8}{\pi^2}}{1 - \frac{8}{\pi^2}} \tag{6}$$

For n = 4 the input impedance $R_x$ is:

$$R_x = R_{SW} \tag{7}$$

Reverting back to Figure 4, it is possible to compute the noise due to both $R_S$ and $R_{SW}$ down-converted from all the harmonics of the LO to baseband (or IF) according to the following formula:

$$\overline{v_n^2}\big|_{Ipm} = 2 \cdot 4kT(R_S + R_{SW}) \cdot \sum_{n,odd}(2 \cdot G_n^2) \approx 32kT(R_S + R_{SW}) \tag{8}$$

wherein

T is the temperature
K is the Boltzmann's constant
$G_n$ is the mixer gain at odd harmonic n as defined in formula (1).

The term $\sum_{n,odd}(2 \cdot G_n^2)$ is approximately equal to 4.

The factor of two in formula (8) accounts for the two sidebands either side of each carrier harmonic, and can be removed in the digital baseband (or IF).

Flicker noise from $V_S$ adds directly but can be removed in practice with AC-coupling.

Therefore, the electric circuit according to the invention has a relatively low noise.

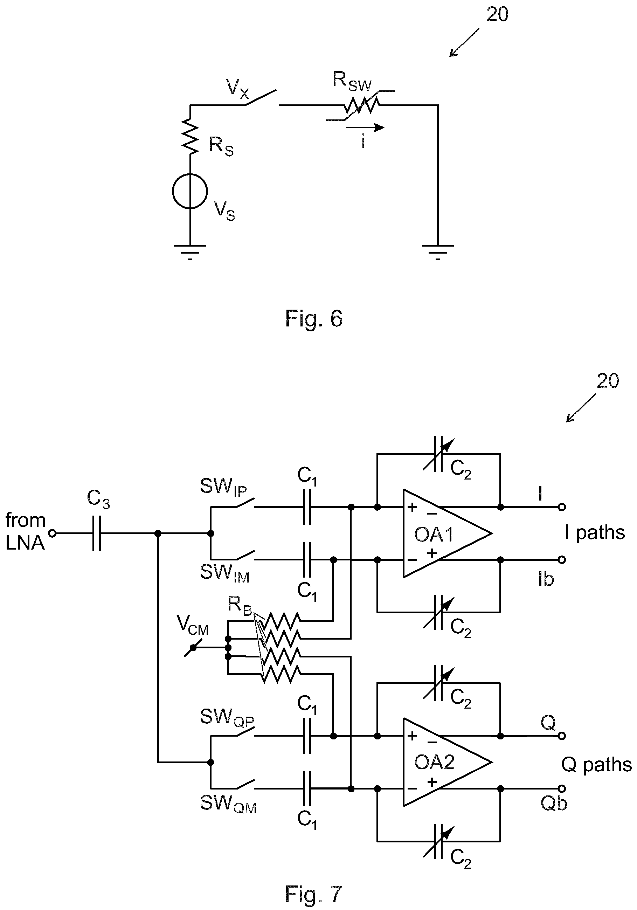

Figure 6 illustrates a schematic representation of an embodiment of a part of the electric circuit 20 according to the invention, in particular for computing its linearity.

For non-overlapping mixer's averaging window, nonlinearity in the mixer is due to the switch nonlinear current-voltage relationship. The current i which flows through the non-ideal switch resistor RSW once it is closed is given by the following formula:

$$i \approx g_1 V_x + g_2 V_x^2 + g_3 V_x^3 \tag{9}$$

wherein

$V_x$ is the voltage across the switch (or at the electric circuit input)
$g_1$ is the first-order transconductance of the switch
$g_2$ is the second-order transconductance of the switch
$g_3$ is the third-order transconductance of the switch.

The IIP3 at the electric circuit input ($V_x$) can then be estimated by the following formula:

$$IIP3 \approx \sqrt{\left| \frac{4\,(1 + g_1\,R_S)^3}{3\,R_S\,g_3} \right|} \tag{10}$$

Simulations performed by the applicant confirm the formula (10) and allow to obtain an IIP3 ≈ 10 dBm.

Therefore, the electric circuit according to the invention has a good linearity (IIP3).

Figure 7 illustrates an embodiment of the electric circuit 20 according to a comparative example not covered by the invention. comprising an I path and a Q path, wherein each of the I path and the Q path comprises:

- two switches (SW$_{IP}$ and SW$_{IM}$ respectively SW$_{QP}$ and SW$_{QM}$),
- an input capacitor C1 between each switch and an input of a fully differential operational amplifier OA1 respectively OA2,

- the fully differential operational amplifier OA1 respectively OA2,
- a feedback capacitor $C_2$ between each input and the output of the operational amplifier.

Although in the embodiment of Figure 7 the operational amplifier is a fully differential operational amplifier, the electric circuit according to the invention is not limited to this fully differential operational amplifier but applies also to (non-fully differential) operational amplifiers. In this case, each of the I path and Q path comprises a single input capacitor $C_1$ and a single feedback capacitor $C_2$.

In the embodiment of Figure 7, each of the I path and Q path comprises two sub-path, named in general as known I path and I bar path, respectively Q path and Q bar path, wherein the term "bar" indicates the negative (minus) part of the processed signal.

The electric circuit 20 of Figure 7 comprises also a (not illustrated) local oscillator connected to the electric circuit and arranged to generate a carrier signal having a carrier frequency and a (not illustrated) command module.

This command module is arranged to sequentially close each switch $SW_{IP}$, $SW_{IM}$, $SW_{QP}$ and $SW_{QM}$ during a mixer's averaging window, so that a RF signal coming from the LNA (via the capacitor $C_3$ in the example of Figure 7) having a frequency close to the carrier frequency results in a non-zero down-converted signal across each input capacitor $C_1$, this down-converted signal being then amplified by each operational amplifier OA1, OA2, so that an amplified down-converted signal appears at the output of each operational amplifier OA1, OA2.

In the embodiment of Figure 7, each of the I and Q path comprises two switches ($SW_{IP}$ and $SW_{IM}$ respectively $SW_{QP}$ and $SW_{QM}$), then there are four switches: the mixer's averaging window is equal to a quarter of the carrier period ($T_{LO}/4$). Therefore, a first switch will be closed during the first quarter of the carrier period (the other three switches being open), a second switch will be closed during the second quarter of the carrier period (the other three switches being open), a third switch will be closed during the third quarter of the carrier period (the other three switches being open) and a fourth switch will be closed during the fourth quarter of the carrier period (the other three switches being open), those four quarters of the carrier period being not overlapping.

In the electric circuit 20 of Figure 7, the voltage gain from the input capacitors $C_1$ to the output of the operational amplifier is equal to $C_1/C_2$, wherein $C_2$ is the feedback capacitor.

In one embodiment, the feedback capacitor(s) $C_2$ is(are) variable feedback capacitor(s), so as to have a variable gain.

In one embodiment, by controlling the variable feedback capacitor, the gain from RF to the frequency translated I/Q outputs can be set to 18dB, 12dB or 6dB.

In the embodiment of Figure 7, at least one (large) bias resistor $R_B$ (four in the example of Figure 7) is connected to the inputs of each operational amplifier OA1, OA2, so as to DC-bias the operational amplifier inputs, e.g. by setting a common-mode level at the operational amplifier inputs.

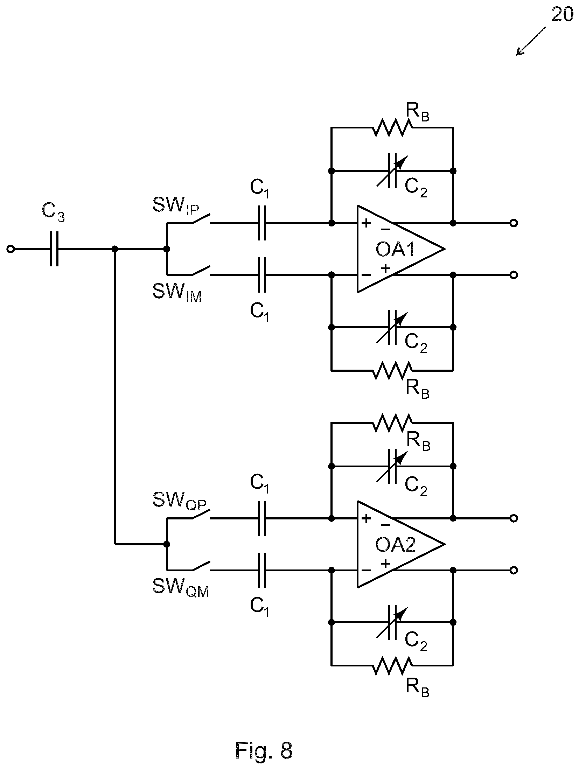

Figure 8 illustrates another embodiment of the electric circuit 20 according to a comparative example not covered by the invention. The embodiment of Figure 8 can be at least partially combined with the embodiment of Figure 7.

In this embodiment, a (large) feedback resistor(s) $R_B$ is(are)across each feedback capacitor(s) $C_2$, so as to DC-bias the operational amplifier inputs. This embodiment is not related to the fact that each operational amplifier OA1 respectively OA2 is a fully differential operational amplifier and works also with non-fully differential operational amplifiers.

The presence of (large) feedback resistor(s) $R_B$ allows to introduce a zero (at zero frequency) and a pole (at $1/(R_B C_2)$) in the baseband (or IF) signal transfer function.

In one embodiment, the feedback resistor(s) $R_B$ is(are) selected so that a pole $\omega$ in a frequency translated signal transfer function is at least 5 times lower in frequency than the wanted frequency translated signal for the gain settings, according to the following formula:

$$\omega > \frac{5}{R_B C_2} \tag{11}$$

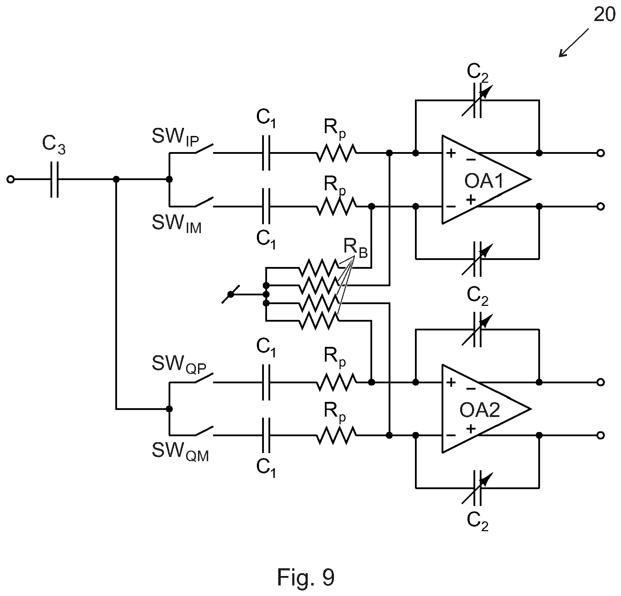

Figure 9 illustrates another embodiment of the electric circuit 20 according to the invention. The embodiment of Figure 9 can be at least partially combined with the embodiment of Figure 8, i.e. the bias resistors $R_B$ could be (in complement or alternative) placed across feedback each capacitor(s) $C_2$.

In the embodiment of Figure 9, the electric circuit 20 comprises a resistor $R_p$ between each switch $SW_{IP}$, $SW_{IM}$, $SW_{QP}$, $SW_{QM}$ and the corresponding input of the operational amplifier OA1 respectively OA2, so as to introduce a pole in the frequency translated transfer function. This embodiment is not related to the fact that each operational amplifier OA1 respectively OA2 is a fully differential operational amplifier and works also with non-fully differential operational amplifiers. In one embodiment, the resistor $R_p$ is between a switch and the corresponding capacitor without altering the operation of the electric circuit.

This embodiment is particularly advantageous as a first-order filter can be embedded in the electric circuit having the transfer function indicated in the following formula:

$$H(s) = \left(-\frac{C_1}{C_2}\right)\frac{1}{1+sR_pC_1} \qquad\qquad (12)$$

The pole of formula (12) can be used as part of the baseband (or IF) filtering if needed at the expense of gain and noise. This helps to simplify the design of the baseband filter and reduces the overall power dissipation.

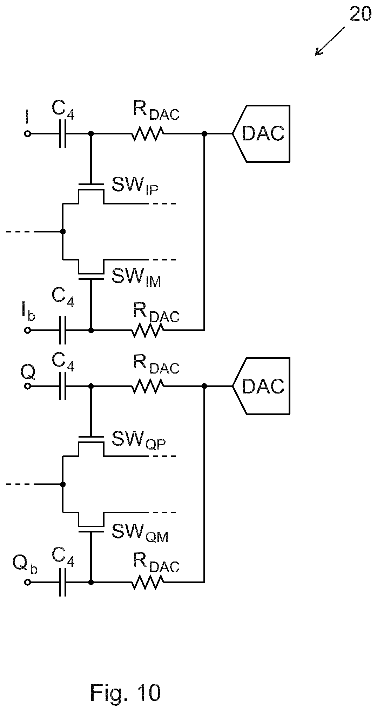

Figure 10 illustrates an embodiment of how to drive the switches of the electric circuit 20 according to certain embodiments.

In one embodiment, the switches have a low or zero onresistance, and are arranged to turn off well (good isolation). A practical implementation uses MOS devices as switches.

The carrier clocks I, $I_b$, Q and $Q_b$ may be coupled directly to the gates of the electric circuit switches $SW_{IP}$, $SW_{IM}$, $SW_{QP}$, $SW_{QM}$ (embodiment not illustrated).

Alternatively, for optimum operation, they are AC-coupled to the gates of the switches $SW_{IP}$, $SW_{IM}$, $SW_{QP}$, $SW_{QM}$ as illustrated in the Figure 10.

In one preferred embodiment, the DC-level at the gates of the switches $SW_{IP}$, $SW_{IM}$, $SW_{QP}$, $SW_{QM}$ may be controlled by a common (not illustrated) or two separate DACs, as illustrated in Figure 10, which can be coupled to the gates by resistors $R_{DAC}$.

Controlling of this DC-level allows for optimum operation of the electric circuit switches $SW_{IP}$, $SW_{IM}$, $SW_{QP}$, $SW_{QM}$.

The present invention also concerns a RF receiver front-end 1, comprising:

- an LNA 10,
- the electric circuit 20 according to the invention, connected to an output of the LNA.

In one embodiment, the LNA can be any known LNA.

In another embodiment, the LNA can be a new and inventive LNA, which will be described in the following.

According to an independent aspect of the invention, the following described LNA is independent of the use of the electric circuit according to the invention.

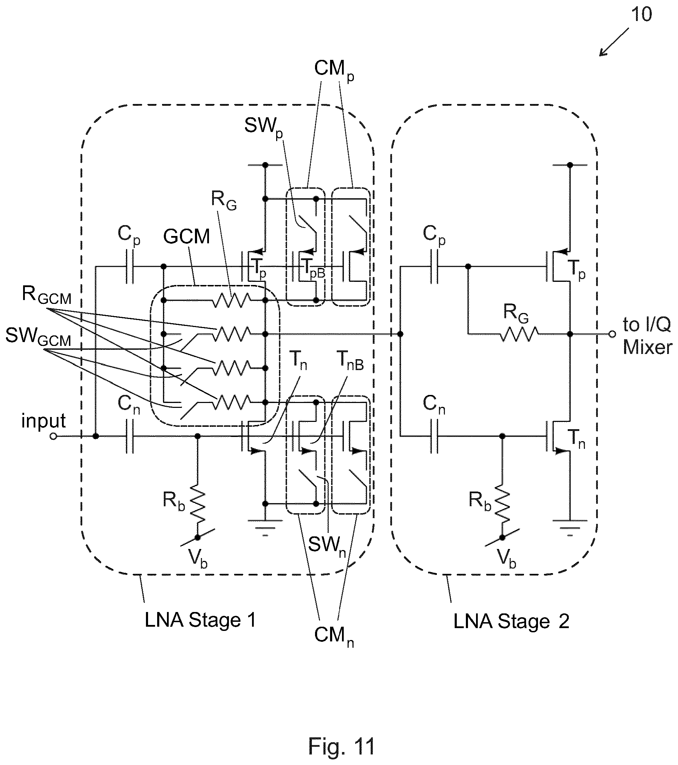

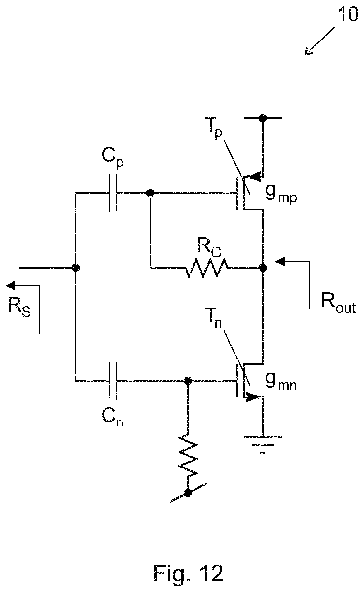

Embodiments of this LNA 10 are visible in Figures 11 and 12.

This LNA 10 comprises (at least one) current-reuse common-source stage (e.g. the LNA stage 1 in Figure 11), the current-reuse common-source stage comprising:

- a p-type transistor $T_p$,
- a n-type transistor $T_n$ sharing a variable current with the p-type transistor $T_p$,
- a gain resistor $R_G$ between a gate and a drain of the p-type transistor $T_p$,
- a first capacitor $C_p$ connected to the gate of the p-type transistor $T_p$,
- a second capacitor $C_n$ connected to the gate of the n-type transistor $T_n$.

The current-reuse common-source stage comprises also

- a p-type bias voltage control module $CM_p$, comprising a first switch $SW_p$ and a p-type bias voltage transistor $T_{pB}$, the first switch $SW_p$ being between a source terminal of the p-type bias voltage transistor $T_{pB}$ and a source terminal of the p-type transistor $T_p$, a gate and a drain of the p-type bias voltage transistor $T_{pB}$ being connected to the gate and the drain of the p-type transistor $T_p$,
- a n-type bias voltage control module $CM_n$, comprising a second switch $SW_n$ and a n-type bias voltage transistor $T_{nB}$, the second switch $SW_n$ being between a source terminal of the n-type bias voltage transistor $T_{nB}$ and a source terminal of the n-type transistor $T_n$, a gate and a drain of the n-type bias voltage transistor $T_{nB}$ being connected to a gate and a drain of the n-type transistor $T_n$.

The LNA comprises also a LNA command module (not illustrated) arranged to control the first switch $SW_p$ and the second switch $SW_n$, so as to operate the current-reuse common-source stage under constant current density, so as to obtain a constant linearity.

This LNA command module could be the same command module of the electric circuit 20 or a different command module.

This LNA 10 presents many advantages: first, it is devoid of inductors. Since the electric circuit 20 is also devoid of inductors, the RF receiver front-end silicon area is drastically reduced since the RF receiver front-end 1 is an inductor-less RF receiver front-end.

Second, the LNA 10 is arranged to operate at constant current density to optimize linearity.

In one embodiment, the LNA comprises at least two p-type bias voltage control modules $CM_p$ and/or at least two n-type bias voltage control modules $CM_n$. In the embodiment of Figure 11, it comprises two p-type bias voltage control modules $CM_p$ and two n-type bias voltage control modules $CM_n$.

For example, if the current of the LNA 10 is 100 μA, then no switches of the bias voltage control modules $CM_p$ respectively $CM_n$ are closed. If the current triples (it raises to 300 μA), then the switch of only one voltage control module $CM_p$ and of only one voltage control module $CM_n$ are closed by the LNA command module, so as to triple (×3) the global channel width W (i.e. the sum of the channel width p/n-type transistor plus the channel width of the p/n-type bias voltage transistor), so that the current density is kept constant.

If the current increases sixfold (it raises to 600 μA), then the switch of two voltage control modules $CM_p$ and of two voltage control module $CM_n$ are closed by the LNA command module, so as to increase sixfold (×6) the global channel width W (i.e. the sum of the channel width p/n-type transistor plus the channel width of the first p/n-type bias voltage transistor plus the channel width of the second p/n-type bias voltage transistor), so that the current density is kept constant.

Third, bias current control of the LNA allows to tradeoff power dissipation for sensitivity. In other words, it is possible to maintain a known sensitivity performance, while reducing power dissipation.

In one embodiment, illustrated in Figure 11, the current-reuse common-source stage comprises a gain control module GCM comprising at least one (e.g. four as in the example of Figure 11) gain control resistor $R_{GCM}$ in series with a third switch $SW_{GCM}$, the series of the gain control resistor $R_{GCM}$ with the third switch $SW_{GCM}$ being in parallel to the gain resistor $R_G$.

In one embodiment, the resistors $R_G$ and $R_{GCM}$ also bias the PMOS devices of the LNA Stage 1.

Typical but non-limitative values of the gain obtained by the gain control module GCM are -6 dB, -12 dB and -18 dB.

Typical but non-limitative values of the total gain of the LNA Stages 1 and 2 is about 30 dB.

In the embodiment of Figure 11, the LNA comprises two, complementary current-reuse common-source stages in series (LNA stage 1 and LNA stage 2), wherein the second is devoid of n-type and p-type bias voltage control modules. In another (not illustrated) embodiment, the second stage comprises also n-type and p-type bias voltage control modules.

In general, the bias current in the LNA stage 1 is traded-off for sensitivity, and the LNA stage 2 is more optimized for linearity. LNA stage 2 also allows to drive the mixer with an elevated impedance (a few hundred Ohms), which in general is beneficial for both the noise and the linearity performance of the mixer.

In the embodiment of Figure 11, bias voltage via resistors $R_B$ sets the operating current. Current dissipation (and performance) is controlled by the first and second switches $SW_p$ and $SW_n$ of the bias voltage control modules $CM_p$ respectively $CM_n$.

Figure 12 illustrates an embodiment of a part of a stage of the LNA (the bias control modules $CM_p$ and $CM_n$ being not illustrated).

Performance metrics as the total gain G, the input resistance $R_{in}$, the output resistance $R_{out}$ and the noise figure NF of each stage are given by the following formulas:

$$G \approx \frac{-g_m R_G}{1 + g_m R_s} \qquad (13)$$

$$R_{in} \approx \frac{1}{g_m}\left(1 + \frac{R_G}{r_o}\right) \qquad (14)$$

$$R_{out} \approx \frac{R_G + R_s}{1 + g_m R_s} // r_o \qquad (15)$$

$$\text{NF} \approx 1 + \gamma + \frac{4}{g_m R_G} \qquad (16)$$

wherein

$g_{mn}$ is the transconductance of the N-device $T_n$
$g_{mp}$ is the transconductance of the P-device $T_p$
$g_m$ is the combined transconductance of the N- and P-devices

$$(g_m = g_{mn} + g_{mp})$$

$R_S$ is the output of the previous stage

$r_o$ is the parallel combination of the N- and P-devices output impedance
$\gamma$ is a process parameter ($\gamma \leq 1$), see (17) below.

Current reuse maximizes the stage transconductance for a given current..

Capacitors $C_p$ and $C_n$ are assumed to be large (small impedance in the frequency range of operation).

Drain noise current in each device is modelled as:

$$\overline{i_n^2} = 4kT\gamma g_m \tag{17}$$

wherein

k is Boltzmann's constant
T is the absolute temperature
$\gamma$ is a process parameter ($\gamma \leq 1$).

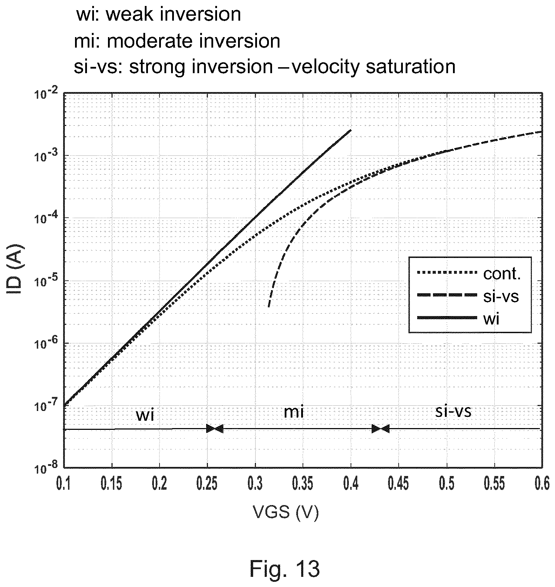

Figure 13 illustrates the drain current $I_D$ of an embodiment of the LNA MOS device of the RF receiver front-end according to the invention, as a function of the gate-source voltage $V_{GS}$ of this LNA MOS device, for showing a general continuous model for a LNA MOS device.

Continuous MOS device model is shown by the following known formulas:

$$I_D = K' \frac{X^2}{1+\theta X} \tag{18}$$

$$K' = \left(\frac{1}{2n}\mu C_{ox}\right)\frac{W}{L} \tag{19}$$

$$X = 2n\phi_t \cdot ln(1 + e^v) \tag{20}$$

$$v = \frac{V_{GS}-V_T}{2n\phi_t} \tag{21}$$

Specific examples for W = 10 $\mu$m and L = 0,05 $\mu$m are:

$$K' = 195\frac{10}{0.05}\left(\frac{\mu A}{V^2}\right), V_T = 0.3\ (V), \theta = 1.35\left(\frac{1}{V}\right), \text{n= 1.1 and } \phi_t = 0.026\ (V)$$

In one embodiment, the p-type transistor and the n-type transistor are operated in a moderate inversion mi (e.g. the moderate inversion illustrated in Figure 13), so as to optimize the IIP3 of the LNA.

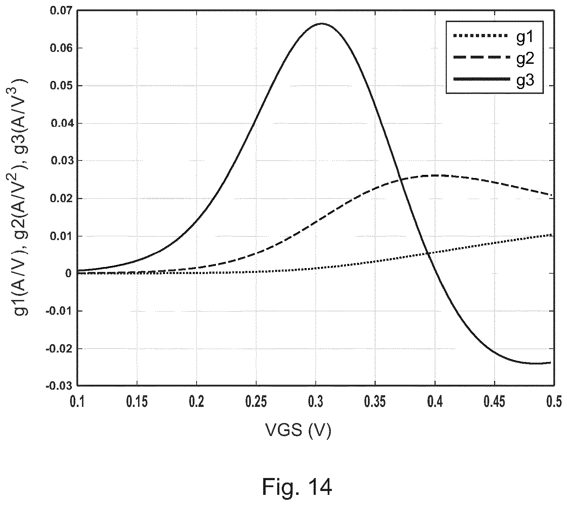

Figure 14 illustrates the first-order transconductance $g_1$, the second-order transconductance $g_2$ and the third-order transconductance $g_3$ of an embodiment of the LNA devices of the RF receiver front-end according to the invention, as a function of the gate-source voltage $V_{GS}$.

Small-signal device current $i_D$ can be expanded in a series for small-signal linearity estimation and expressed as a function of the small-signal gate-source voltage $v_{gs}$ as following:

$$i_D = g_1 v_{gs} + g_2 v_{gs}^2 + g_3 v_{gs}^3 \tag{22}$$

Device linearity figures IIP2 and IIP3 can be estimated from the following formulas:

$$\text{IIP2} = \left|\frac{g_1}{g_2}\right| \tag{23}$$

$$\text{IIP3} = \sqrt{\frac{4}{3}\left|\frac{g_1}{g_3}\right|} \tag{24}$$

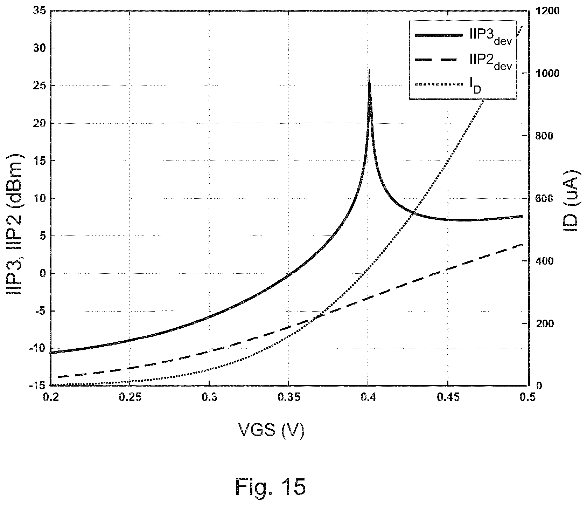

Figure 15 illustrates the IIP3, IIP2 and the drain current of an embodiment of the LNA devices of the RF receiver front-end according to the invention, as a function of the gate-source voltage of these LNA devices.

Device IIP3 is expected to peak when $g_3$ crosses zero, as illustrated by considering both Figures 14 and 15.

Therefore, in one embodiment the optimum LNA IIP3 is achieved in upper moderate inversion towards the onset of strong inversion.

In one embodiment, the LNA IIP2 increases monotonically with power dissipation.

In one embodiment, decreasing LNA transistors' length moves the optimum IIP3 point towards lower $V_{GS}$ (for similar $g_m/I$ ratio). This decreases the LNA capacitance, but increases thermal noise, as $\gamma$ increases.

In one embodiment, changing LNA transistors' width to keep the LNA linearity constant as the bias current is changing, the device should operate at a set current density given by the following formula:

$$\frac{I_D}{W} = \left(\frac{1}{2n}\mu C_{ox}\right)\frac{1}{L} \cdot \frac{X^2}{1+\theta X} \qquad\qquad (25)$$

wherein

I$_D$ is he LNA transistor current
W is the total channel width of the (p- or n-type) transistor
L is the channel length of the (p- or n-type) LNA transistor
$\mu$, $C_{ox}$, n, $\theta$ are known process parameters.

For specific channel length L, the right-hand side in the equation above depends only on $V_{GS}$, and the thermal voltage $\varphi_t$. Therefore, IIP2 and IIP3 remain constant if $I_D$ and W are ratioed together with constant $V_{GS}$.

In one embodiment, the front-end comprises a baseband (or IF) amplifier, connected to an output of the electric circuit and arranged so as to provide a baseband (or IF) gain depending on the LNA gain and on the electric circuit gain, so as to have e.g. a given total gain of the front-end.

In one embodiment, the baseband (or IF) amplifier is a baseband (or IF) filter.

In one embodiment, this baseband (or IF) filter is a known baseband (or IF) filter providing a gain.

In another embodiment, this baseband (or IF) filter can be a new and inventive baseband (or IF) filter, which will be described in the following.

According to an independent aspect of the invention, the following described baseband (or IF) filter is independent on the use of the electric circuit and/or of the LNA according to the invention.

In one embodiment, this baseband (or IF) filter is arranged to be configured as a two pole filter, as a single pole filter or it can be bypassed, so as to trade-off its sharpness for power dissipation. In this embodiment, the baseband (or IF) filter has then a reconfigurable topology that saves power in the analog baseband (or IF) at the expense of the carrier to interference ratio (C/I) and/or alias attenuation.

In one embodiment, the two pole filter is a polynomial filter, e.g. a Tow-Thomas filter, a voltage-controlled voltage-source (VCVS) filter or controlled-source filter such as a Sallen-Key filter.

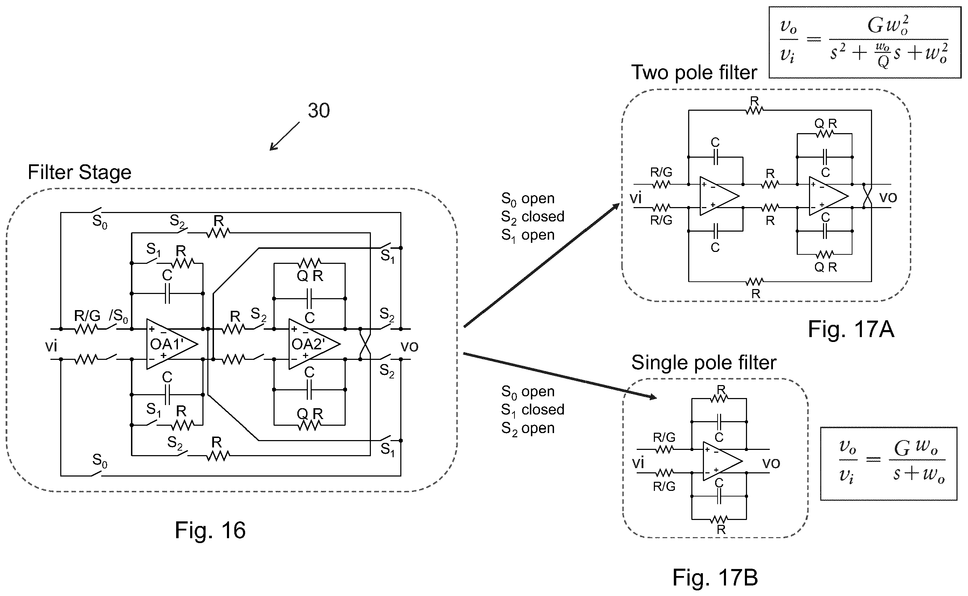

Figure 16 illustrates an embodiment of a baseband (or IF) filter 30 according to the invention. It comprises two operational amplifiers OA1' and OA2', which in Figure 16 are fully differential (although this is not necessary for the working of the baseband (or IF) filter 30).

The baseband (or IF) filter 30 comprise a baseband (or IF) command module (not illustrated) arranged to open/close switches $S_0$, $/S_0$, $S_1$ and $S_2$. The switch $S_0$ directly links the input to the output of the baseband (or IF) filter 30. The working of the switch $/S_0$, which precedes the first operational amplifiers OA1', is complementary to the working of the switch $S_0$: therefore, once the switch $S_0$ is closed, the switch $/S_0$ is open and vice-versa.

In one embodiment, the baseband (or IF) command module is arranged so as to close the switch $S_0$ (and therefore open the switch $/S_0$): this allows to completely by-pass the filter stage 30. In this case, preferably the switches $S_1$ and $S_2$ are open, so as to avoid the dissipation power by the operational amplifiers OA1' and OA2'. Also the operational amplifiers are powered down.

In the embodiment of Figure 16, the (differential) input of the filter 30 is followed by a resistor having value R/G, wherein G is the gain of the filter 30, in series with the switch $/S_0$ and the (differential) input of the first (differential) operational amplifier OA1'. The operational amplifier OA1' can form with the feedback capacitor C and the resistor R (this last being in parallel to the feedback capacitor C and in series with a switch $S_1$) a lossless integrator, once the switch $S_1$ is open.

Another resistor R in series with a switch $S_2$ connects each output of the first (differential) operational amplifier OA1' to the input of the second (differential) operational amplifier OA2'. The operational amplifier OA2' forms with the feedback capacitor C and the resistor having value QR (Q being the filter quality factor) a lossy integrator.

Each output of the second (differential) operational amplifier OA2' is connected to the respective output of the filter 30 via a switch $S_2$.

Each output of the first (differential) operational amplifier OA1' is connected to the alternative output of the filter 30 via a switch $S_1$.

Each input of the first (differential) operational amplifier OA1' is connected to the alternative output of the second (differential) operational amplifier OA2' via a switch $S_2$ in series with a resistor R.

In a first possible configuration of the baseband (or IF) filter of Figure 16, illustrated in Figure 17A, the command module is arranged so as to:

- open the switch $S_0$ (and therefore close the switch $/S_0$),
- open the switches $S_1$,
- close the switches $S_2$.

In this configuration, this baseband (or IF) filter is a two pole filter.

In one embodiment, the two pole filter is a polynomial filter, e.g. a Tow-Thomas filter, a voltage-controlled voltage-source (VCVS) filter or controlled-source filter such as a Sallen-Key filter.

In the embodiment of Figure 17A, the two pole filter is a Tow-Thomas filter, with a natural frequency $\omega_0 = 1/(RC)$.

In the embodiment of Figure 17A, the filter comprises two integrators, with the second one comprises a feedback resistor having its value multiplied by the quality factor Q of the filter, for improving the filter noise performances. In other words, the Tow-Thomas filter is arranged to have the lossless integrator first for reduced noise.

Figure 17B illustrates a second possible configuration of the baseband (or IF) filter of Figure 16.

In this configuration, this baseband (or IF) filter is a single pole filter with a corner frequency $\omega_0 = 1/(RC)$.

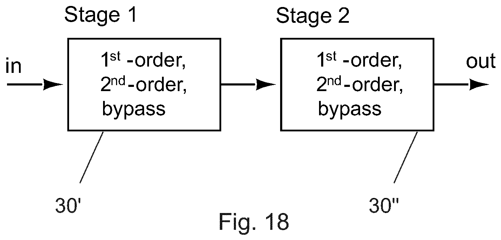

Figure 18 illustrates another embodiment of the baseband (or IF) filter of the RF receiver front-end according to one embodiment of the invention.

In this embodiment, the baseband (or IF) filter is a first stage baseband (or IF) filter 30' (which can be by-passed, morphed in a first order filter or morphed in a second order filter), the front-end comprising a second stage baseband (or IF) filter 30" in series with the first stage baseband (or IF) filter (which can be by-passed, morphed in a first order filter or morphed in a second order filter).

In one embodiment, the first stage baseband (or IF) filter 30' has a quality factor lower than the second stage 30" baseband (or IF) filter to avoid peaking at the output of the first stage filter 30'.

In one embodiment, (at least) two filter stages 30', 30" are placed in series to achieve 1st-, 2nd-, 3rd- & 4th-order characteristic, e.g. according to the configuration table below:

Table 1

| Stage 1 | | Stage2 | | |
|---|---|---|---|---|
| Order | Q | Order | Q | Overall |
| 1 | - | bypass | - | Butterworth 1st |
| 2 | 0.707 | bypass | - | Butterworth 2nd |
| 2 | 1 | 1 | - | Butterworth 3rd |
| 2 | 0.541 | 2 | 1.307 | Butterworth 4th |

In one embodiment, each filter stage 30', 30" can provide 18 dB, 12 dB, 6 dB, 0 dB gain.

In one embodiment, when implementing a 4th-order Butterworth filter, the low-Q second order stage is placed first to avoid peaking in the internal node.

By summarizing, in an RF front-end comprising the electric circuit, the LNA and the baseband (or IF) filter according to the inventions, the following advantages can be obtained:

- the front-end is inductor-less, which drastically reduces silicon area by eliminating the use of inductors,
- current dissipation in the front-end is efficiently traded off for sensitivity while S11 remains under control
- the active averaging mixer relaxes gain requirements in the baseband (or IF) filter,
- the flexible, reconfigurable baseband (or IF) filter synthesizes up to 4th-order responses for demanding C/I applications, and permits to aggressively reduce power when C/I performance can be allowed to degrade,
- it is possible to obtain the same sensitivity of known front-end with 6% lower power and similar C/I performance,
- 1.8 dB sensitivity hit with 18% lower power and similar C/I performance,
- 1.8 dB sensitivity hit with up to 42% lower power in applications where C/I can be allowed to degrade.

**Claims**

1. An electric circuit providing mixing and gaining functions (20) for a RF receiver front-end (1), the electric circuit (20) comprising an I path and a Q path, wherein each of the I path and the Q path comprises:

   - a switch ($SW_{IP}$, $SW_{QP}$),
   - an input capacitor ($C_1$) having a first terminal connected to the switch ($SW_{IP}$, $SW_{QP}$) and a second terminal connected to an input of an operational amplifier (OA1, OA2),
   - the operational amplifier (OA1, OA2),
   - a feedback capacitor ($C_2$) having a first terminal connected to the input of the operational amplifier (OA1, OA2) and a second terminal connected to the output of the operational amplifier (OA1, OA2),

   the electric circuit (20) comprising:

   - a bias resistor ($R_B$) so as to DC-bias the operational amplifier input,
   - a local oscillator arranged to generate a carrier signal having a carrier frequency, a gate of the switch being coupled to the local oscillator,
   - a command module arranged to sequentially close each switch ($SW_{IP}$, $SW_{QP}$) during a mixer's averaging window, so that an incoming signal having a frequency close to the carrier frequency, i.e. a frequency belonging to a mixer's bandwidth (BW), results in a non-zero down-converted signal across the input capacitor ($C_1$), this down-converted signal being then amplified by the operational amplifier (OA1, OA2) so that an amplified down-converted signal appears at the output of the operational amplifier (OA1, OA2),

   **characterized in that** the electric circuit comprises a resistor ($R_p$) between each input capacitor ($C_1$) and the corresponding input of the operational amplifier (OA1, OA2), so as to introduce a pole in the baseband or IF transfer function.

2. The electric circuit(20) of claim 1, wherein the mixer bandwidth is given by the formula:

$$BW = 2\,\frac{1}{2\pi \cdot 4(R_S + R_{SW})C_1},$$

   wherein

   $R_S$ is the resistance of a source resistor connected to the switch ($SW_{IP}$, $SW_{QP}$),
   $R_{SW}$ is the resistance of each switch ($SW_{IP}$, $SW_{QP}$) once it is closed $C_1$ is the capacitance of each input capacitor.

3. The electric circuit (20) of one of claims 1 or 2, wherein the operational amplifier (OA1, OA2) is a fully differential operational amplifier, wherein the switch ($SW_{IP}$, $SW_{QP}$) is a first switch, wherein the input capacitor ($C_1$) is a first input capacitor, wherein the input is a first input, wherein the output is a first output, wherein the mixer's averaging window is a first mixer's averaging window, wherein each of the I path and the Q path comprises:

   - a second switch ($SW_{IM}$, $SW_{QM}$),
   - a second input capacitor ($C_1$) between the second switch ($SW_{IM}$, $SW_{QM}$) and a second input of the differential operational amplifier (OA1, OA2),
   - a second feedback capacitor ($C_2$) between the second input and a second output of the operational amplifier (OA1, OA2),

   wherein the command module is arranged to sequentially close each switch ($SW_{IP}$, $SW_{QP}$, $SW_{IM}$, $SW_{QM}$) during a second mixer's averaging window, so that said incoming signal results in a non-zero down-converted signal across the input capacitors ($C_1$), this down-converted signal being then amplified by the differential operational amplifier (OA1, OA2) so that an amplified down-converted signal appears at the first and second outputs of the differential operational amplifier (OA1, OA2).

4. The electric circuit (20) of one of claims 1 to 3, wherein the bias resistor ($R_B$) is placed at the operational amplifier input(s) and/or wherein the bias resistor ($R_B$) is a feedback resistor ($R_B$) across each feedback capacitor(s) ($C_2$).

**5.** The electric circuit (20) of claim 4, wherein the feedback resistor(s) ($R_B$) is(are) selected so that a pole in a baseband or IF signal transfer function is at least five times lower in frequency than the wanted baseband or IF signal for the gain settings.

**6.** The electric circuit (20) of one of claims 1 to 5, wherein a gate of each switch is AC-coupled to the local oscillator.

**7.** A front-end (1) of a RF receiver, comprising:

- an LNA (10),
- the electric circuit (20) of one of claims 1 to 6, connected to an output of the LNA (10).

**8.** The front-end (1) of claim 7, wherein the LNA comprises a current-reuse common-source stage, the current-reuse common-source stage comprising:

- a p-type transistor ($T_p$),
- a n-type transistor ($T_n$) sharing a variable current with the p-type transistor,
- a gain resistor ($R_G$) between a gate and a drain of the p-type transistor,
- a first capacitor ($C_p$) connected to the gate of the p-type transistor ($T_p$),
- a second capacitor ($C_n$) connected to the gate of the n-type transistor ($T_n$),
- a p-type bias voltage control module ($CM_p$), comprising a first switch ($SW_p$) and a p-type bias voltage transistor ($T_{pB}$), the first switch ($SW_p$) being between a source terminal of the p-type bias voltage transistor ($T_{pB}$) and a source terminal of the p-type transistor ($T_p$), a gate and a drain of the p-type bias voltage transistor ($T_{pB}$) being connected to the gate and the drain of the p-type transistor ($T_p$),
- a n-type bias voltage control module ($CM_n$), comprising a second switch ($SW_n$) and a n-type bias voltage transistor ($T_{nB}$), the second switch ($SW_n$) being between a source terminal of the n-type bias voltage transistor ($T_{nB}$) and a source terminal of the n-type transistor ($T_n$), a gate and a drain of the n-type bias voltage transistor ($T_{nB}$) being connected to a gate and a drain of the n-type transistor ($T_n$),
- a LNA command module arranged to control the first switch ($SW_p$) and the second switch ($SW_n$) so as to operate the current-reuse common-source stage under constant current density, so as to obtain a constant linearity

**9.** The front-end of claim 8, wherein the LNA comprises at least two p-type bias voltage control modules ($CM_p$) and/or at least two n-type bias voltage control modules ($CM_n$).

**10.** The front-end of one of claims 8 to 9, wherein the current-reuse common-source stage comprises a gain control module (GCM), wherein the gain control module (GCM) comprises at least one gain control resistor ($R_{GCM}$) in series with a third switch ($SW_{GCM}$), the series of the gain control resistor ($R_{GCM}$) with the third switch ($SW_{GCM}$) being in parallel to the gain resistor ($R_G$).

**11.** The front-end of one of claims 8 to 10, wherein the p-type transistor ($T_p$) and the n-type transistor ($T_n$) are operated in a moderate inversion, so as to optimize an IIP3 of the LNA.

**12.** The front-end of one of claims 8 to 11, comprising a baseband or IF amplifier (30), connected to an output of the electric circuit (20) and arranged so as to provide a baseband or IF gain depending on the LNA gain and on the electric circuit gain.

**13.** The front-end of claim 12, the baseband or IF amplifier being a baseband or IF filter.

**14.** The front-end of claim 13, wherein the baseband or IF filter (30) is arranged to be configured as a two pole filter, as a single pole filter or it can be bypassed, so as to trade-off its sharpness for power dissipation and/or wherein the baseband or IF filter is a first stage baseband or IF filter (30'), the front-end comprising a second stage baseband or IF filter (30") in series with the first stage baseband or IF filter (30').

**Patentansprüche**

**1.** Elektrische Schaltung (20), welche Misch- und Verstärkungsfunktionen für ein HF-Empfänger-Frontend (1) bereitstellt, wobei die elektrische Schaltung (20) einen I-Pfad und einen Q-Pfad umfasst, wobei der I-Pfad und der Q-Pfad jeweils Folgendes umfassen:

einen Schalter ($SW_{IP}$, $SW_{QP}$),

einen Eingangskondensator ($C_1$), dessen erster Anschluss mit dem Schalter ($SW_{IP}$, $SW_{QP}$) und dessen zweiter Anschluss mit einem Eingang eines Operationsverstärkers (OA1, OA2) verbunden ist,

den Operationsverstärker (OA1, OA2),

einen Rückkopplungskondensator ($C_2$), dessen erster Anschluss mit dem Eingang des Operationsverstärkers (OA1, OA2) und dessen zweiter Anschluss mit dem Ausgang des Operationsverstärkers (OA1, OA2) verbunden ist,

wobei die elektrische Schaltung (20) umfasst:

einen Vorspannungswiderstand ($R_B$), um den Eingang des Operationsverstärkers mit Gleichstrom vorzuspannen,

einen lokalen Oszillator, welcher dazu eingerichtet ist, ein Trägersignal mit einer Trägerfrequenz zu erzeugen, wobei ein Gate des Schalters mit dem lokalen Oszillator gekoppelt ist,

ein Befehlsmodul, welches dazu eingerichtet ist, jeden Schalter ($SW_{IP}$, $SW_{QP}$) während eines Mittelungsfensters eines Mischers sequentiell zu schliessen, so dass ein eingehendes Signal mit einer Frequenz nahe der Trägerfrequenz, d. h. einer Frequenz, die zur Bandbreite (BW) eines Mischers gehört, zu einem von Null verschiedenen abwärtsgemischten Signal am Eingangskondensator ($C_1$) führt, wobei dieses abwärtsgemischte Signal dann durch den Operationsverstärker (OA1, OA2) verstärkt wird, so dass am Ausgang des Operationsverstärkers (OA1, OA2) ein verstärktes abwärtsgemischtes Signal erscheint,

**dadurch gekennzeichnet, dass**

die elektrische Schaltung einen Widerstand ($R_p$) zwischen jedem Eingangskondensator ($C_1$) und dem entsprechenden Eingang des Operationsverstärkers (OA1, OA2) umfasst, um einen Pol in die Basisband- oder ZF-Übertragungsfunktion einzuführen.

2. Elektrische Schaltung (20) gemäss Anspruch 1, worin die Mischerbandbreite durch die folgende Formel gegeben ist:

$$BW = 2\, \frac{1}{2\pi \cdot 4(R_S + R_{SW})C_1},$$

worin

Rs der Widerstandswert eines mit dem Schalter verbundenen Quellwiderstands ($SW_{IP}$, $SW_{QP}$) ist,
Rsw der Widerstand jedes Schalters ($SW_{IP}$, $SW_{QP}$) ist, sobald er geschlossen ist,
$C_1$ die Kapazität jedes Eingangskondensators ist.

3. Elektrische Schaltung (20) gemäss einem der Ansprüche 1 oder 2, worin der Operationsverstärker (OA1, OA2) ein volldifferenzieller Operationsverstärker ist, worin der Schalter ($SW_{IP}$, $SW_{QP}$) ein erster Schalter ist, worin der Eingangskondensator ($C_1$) ein erster Eingangskondensator ist, worin der Eingang ein erster Eingang ist, worin der Ausgang ein erster Ausgang ist, worin das Mittelungsfenster des Mischers ein Mittelungsfenster des ersten Mischers ist, worin der I-Pfad und der Q-Pfad jeweils Folgendes umfassen:

einen zweiten Schalter ($SW_{IM}$, $SW_{QM}$),
einen zweiten Eingangskondensator ($C_1$) zwischen dem zweiten Schalter ($SW_{IM}$, $SW_{QM}$) und einem zweiten Eingang des differenzialen Operationsverstärkers (OA1, OA2),
einen zweiten Rückkopplungskondensator ($C_2$) zwischen dem zweiten Eingang und einem zweiten Ausgang des Operationsverstärkers (OA1, OA2),
worin das Befehlsmodul dazu eingerichtet ist, jeden Schalter ($SW_{IP}$, $SW_{QP}$, $SW_{IM}$, $SW_{QM}$) während eines Mittelungsfensters eines zweiten Mischers sequentiell zu schliessen, so dass das eingehende Signal zu einem von Null verschiedenen abwärtsgemischten Signal über den Eingangskondensatoren ($C_1$) führt, wobei dieses abwärtsgemischte Signal dann durch den differenzialen Operationsverstärker (OA1, OA2) verstärkt wird, so dass ein verstärktes abwärtsgemischtes Signal am ersten und zweiten Ausgang des differenzialen Operationsverstärkers (OA1, OA2) erscheint.

4. Elektrische Schaltung (20) gemäss einem der Ansprüche 1 bis 3, worin der Vorspannungswiderstand ($R_B$) an dem/den Eingang(en) des Operationsverstärkers angeordnet ist und/oder worin der Vorspannungswiderstand ($R_B$) ein Rückkopplungswiderstand ($R_B$) über jedem/jeden Rückkopplungskondensator(en) ($C_2$) ist.

5. Elektrische Schaltung (20) gemäss Anspruch 4, worin der/die Rückkopplungswiderstand/Widerstände ($R_B$) so ausgewählt ist/sind, dass ein Pol in einer Basisband- oder ZF-Signalübertragungsfunktion eine mindestens fünfmal niedrigere Frequenz aufweist als das gewünschte Basisband- oder ZF-Signal für die Verstärkungseinstellungen.

6. Elektrische Schaltung (20) gemäss einem der Ansprüche 1 bis 5, worin ein Gate jedes Schalters wechselstrommässig mit dem lokalen Oszillator gekoppelt ist.

7. Frontend (1) eines HF-Empfängers, umfassend:

   einen LNA (10),
   die elektrische Schaltung (20) gemäss einem der Ansprüche 1 bis 6, welche mit einem Ausgang des LNAs (10) verbunden ist.

8. Frontend (1) gemäss Anspruch 7, worin der LNA eine Common-Source-Stufe mit Stromwiederverwendung umfasst, wobei die Common-Source-Stufe mit Stromwiederverwendung Folgendes umfasst:

   einen p-Typ-Transistor ($T_p$),
   einen n-Typ-Transistor ($T_n$), welcher einen variablen Strom mit dem p-Typ-Transistor teilt,
   einen Verstärkungswiderstand ($R_G$) zwischen einem Gate und einem Drain des p-Typ-Transistors,
   einen ersten Kondensator ($C_p$), welcher mit dem Gate des p-Typ-Transistors (TP) verbunden ist,
   einen zweiten Kondensator ($C_n$), welcher mit dem Gate des n-Typ-Transistors ($T_n$) verbunden ist,
   ein p-Typ-Vorspannungssteuermodul ($CM_p$), welches einen ersten Schalter ($SW_p$) und einen p-Typ-Vorspannungstransistor ($T_{pB}$) umfasst, wobei der erste Schalter ($SW_p$) zwischen einem Source-Anschluss des p-Typ-Vorspannungstransistors ($T_{pB}$) und einem Source-Anschluss des p-Typ-Transistors ($T_p$) liegt, ein Gate und ein Drain des p-Typ-Vorspannungstransistors ($T_{pB}$), mit dem Gate und dem Drain des p-Typ-Transistors ($T_p$) verbunden,
   ein n-Typ-Vorspannungssteuermodul ($CM_n$), welches einen zweiten Schalter ($SW_n$) und einen n-Typ-Vorspannungstransistor ($T_{nB}$) umfasst, wobei der zweite Schalter ($SW_n$) zwischen einem Source-Anschluss des n-Typ-Vorspannungstransistors ($T_{nB}$) und einem Source-Anschluss des n-Typ-Transistors ($T_n$) liegt, ein Gate und ein Drain des n-Typ-Vorspannungstransistors ($Tn_B$), mit einem Gate und einem Drain des n-Typ-Transistors ($T_n$) verbunden,
   ein LNA-Befehlsmodul, welches dazu eingerichtet ist, den ersten Schalter ($SW_p$) und den zweiten Schalter ($SW_n$) zu steuern, um die Common-Source-Stufe mit Stromwiederverwendung mit konstanter Stromdichte zu betreiben, um eine konstante Linearität zu erreichen.

9. Front-End gemäss Anspruch 8, worin der LNA mindestens zwei p-Typ-Vorspannungssteuermodule ($CM_p$) und/oder mindestens zwei n-Typ-Vorspannungssteuermodule ($CM_n$) umfasst.

10. Front-End gemäss einem der Ansprüche 8 bis 9, worin die Common-Source-Stufe mit Stromwiederverwendung ein Verstärkungssteuermodul (GCM) umfasst, worin das Verstärkungssteuermodul (GCM) mindestens einen Verstärkungssteuerwiderstand ($R_{GCM}$) in Reihe mit einem dritten Schalter ($SW_{GCM}$) umfasst, wobei die Reihe des Verstärkungssteuerwiderstands ($R_{GCM}$) mit dem dritten Schalter ($SW_{GCM}$) parallel zum Verstärkungswiderstand ($R_G$) liegt.

11. Front-End gemäss einem der Ansprüche 8 bis 10, worin der p-Typ-Transistor ($T_p$) und der n-Typ-Transistor ($T_n$) in einer moderaten Inversion betrieben werden, um einen IIP3 des LNAs zu optimieren.

12. Front-End gemäss einem der Ansprüche 8 bis 11, welches einen Basisband- oder ZF-Verstärker (30) umfasst, der mit einem Ausgang der elektrischen Schaltung (20) verbunden ist und so angeordnet ist, um eine Basisband- oder ZF-Verstärkung bereitzustellen, die von der LNA-Verstärkung und der Verstärkung der elektrischen Schaltung abhängt.

13. Front-End gemäss Anspruch 12, wobei der Basisband- oder ZF-Verstärker ein Basisband- oder ZF-Filter ist.

14. Front-End gemäss Anspruch 13, worin das Basisband- oder ZF-Filter (30) so angeordnet ist, dass es als Zweipolfilter oder als Einpolfilter konfiguriert werden kann oder umgangen werden kann, um seine Schärfe gegen Leistungsverlust einzutauschen, und/oder worin das Basisband- oder ZF-Filter ein Basisband- oder ZF-Filter der ersten Stufe (30') ist und das Front-End ein Basisband- oder ZF-Filter der zweiten Stufe (30") in Reihe mit dem Basisband- oder ZF-Filter der ersten Stufe (30') umfasst.

**Revendications**

1. Un circuit électrique assurant des fonctions de mélange et de gain (20) pour une partie frontale d'un récepteur RF (1), le circuit électrique (20) comprenant un chemin I et un chemin Q, dans lequel chacun du chemin I et du chemin Q comprend :

   - un commutateur ($SW_{IP}$, $SW_{QP}$),
   - un condensateur d'entrée ($C_1$) ayant une première borne connectée au commutateur ($SW_{IP}$, $SW_{QP}$) et une seconde borne connectée à une entrée d'un amplificateur opérationnel (OA1, OA2),
   - l'amplificateur opérationnel (OA1, OA2),
   - un condensateur de rétroaction ($C_2$) ayant une première borne connectée à l'entrée de l'amplificateur opérationnel (OA1, OA2) et une seconde borne connectée à la sortie de l'amplificateur opérationnel (OA1, OA2),

   le circuit électrique (20) comprenant

   - une résistance de polarisation ($R_B$) de manière à polariser en courant continu l'entrée de l'amplificateur opérationnel,
   - un oscillateur local configuré pour générer un signal porteur ayant une fréquence porteuse, une porte de l'interrupteur étant couplée à l'oscillateur local,
   - un module de commande configuré pour fermer séquentiellement chaque interrupteur ($SW_{IP}$, $SW_{QP}$) pendant une fenêtre de moyennage du mélangeur, de sorte qu'un signal entrant ayant une fréquence proche de la fréquence porteuse, c'est-à-dire une fréquence appartenant à la largeur de bande (BW) d'un mélangeur, donne lieu à un signal converti vers le bas non nul sur le condensateur d'entrée ($C_1$), ce signal converti vers le bas étant ensuite amplifié par l'amplificateur opérationnel (OA1, OA2) de sorte qu'un signal converti vers le bas amplifié apparaisse à la sortie de l'amplificateur opérationnel (OA1, OA2),

   **caractérisé en ce que**
   le circuit électrique comprend une résistance ($R_p$) entre chaque condensateur d'entrée ($C_1$) et l'entrée correspondante de l'amplificateur opérationnel (OA1, OA2), de manière à introduire un pôle dans la fonction de transfert en bande de base ou IF.

2. Le circuit électrique (20) de la revendication 1, dans lequel la largeur de bande du mélangeur est donnée par la formule :

$$BW = 2\,\frac{1}{2\pi\cdot 4(R_S+R_{SW})C_1},$$

   dans laquelle

   $R_S$ est la résistance d'une résistance de source connectée à l'interrupteur ($SW_{IP}$, $SW_{QP}$),
   $R_{SW}$ est la résistance de chaque interrupteur ($SW_{IP}$, $SW_{QP}$) une fois qu'il est fermé
   $C_1$ est la capacité de chaque condensateur d'entrée.

3. Le circuit électrique (20) de l'une des revendications 1 ou 2, dans lequel l'amplificateur opérationnel (OA1, OA2) est un amplificateur opérationnel entièrement différentiel, dans lequel le commutateur ($SW_{IP}$, $SW_{QP}$) est un premier commutateur, dans lequel le condensateur d'entrée ($C_1$) est un premier condensateur d'entrée, dans lequel l'entrée est une première entrée, dans lequel la sortie est une première sortie, dans lequel la fenêtre de moyennage du mélangeur est une première fenêtre de moyennage du mélangeur, dans lequel chacun des chemins I et Q comprend :

   - un second commutateur ($SW_{IM}$, $SW_{QM}$)
   - un deuxième condensateur d'entrée ($C_1$) entre le deuxième commutateur ($SW_{IM}$, $SW_{QM}$) et une deuxième entrée de l'amplificateur opérationnel différentiel (OA1, OA2),
   - un deuxième condensateur de rétroaction ($C_2$) entre la deuxième entrée et une deuxième sortie de l'amplificateur opérationnel (OA1, OA2), dans lequel le module de commande est configuré pour fermer séquentiellement chaque commutateur ($SW_{IP}$, $SW_{QP}$, $SW_{IM}$, $SW_{QM}$) pendant une deuxième fenêtre de moyennage du mélangeur, de sorte que ledit signal entrant donne lieu à un signal converti vers le bas non nul sur les condensateurs d'entrée ($C_1$), ce signal converti vers le bas étant ensuite amplifié par l'amplificateur opérationnel

differentiel (OA1, OA2) de sorte qu'un signal converti vers le bas amplifié apparaît aux première et deuxième sorties de l'amplificateur opérationnel différentiel (OA1, OA2).

4. Le circuit électrique (20) de l'une des revendications 1 à 3, dans lequel la résistance de polarisation ($R_B$) est placée à l'entrée ou aux entrées de l'amplificateur opérationnel et/ou dans lequel la résistance de polarisation ($R_B$) est une résistance de rétroaction ($R_B$) sur chaque condensateur de rétroaction ($C_2$).

5. Le circuit électrique (20) de la revendication 4, dans lequel la (les) résistance(s) de rétroaction ($R_B$) est (sont) sélectionnée(s) de manière qu'un pôle de la fonction de transfert d'un signal en bande de base ou IF soit au moins cinq fois plus bas en fréquence que le signal en bande de base ou IF pour les réglages de gain.

6. Le circuit électrique (20) de l'une des revendications 1 à 5, dans lequel une porte de chaque commutateur est couplée en courant alternatif à l'oscillateur local.

7. Partie frontale (1) d'un récepteur RF, comprenant :

   - un LNA (10),
   - le circuit électrique (20) de l'une des revendications 1 à 6, connecté à une sortie du LNA (10).

8. La partie frontale (1) de la revendication 7, dans lequel le LNA comprend un étage à source commune à réutilisation de courant, l'étage à source commune à réutilisation de courant comprenant :

   - un transistor de type p ($T_p$),
   - un transistor de type n ($T_n$) partageant un courant variable avec le transistor de type p,
   - une résistance de gain ($R_G$) entre une grille et un drain du transistor de type p,
   - un premier condensateur ($C_p$) connecté à la grille du transistor de type p ($T_p$),
   - un second condensateur ($C_n$) connecté à la grille du transistor de type n ($T_n$),
   - un module de contrôle de la tension de polarisation de type p ($CM_p$), comprenant un premier interrupteur ($SW_p$) et un transistor de tension de polarisation de type p ($T_{pB}$), le premier interrupteur ($SW_p$) se trouvant entre une borne de source du transistor de tension de polarisation de type p ($T_{pB}$) et une borne de source du transistor de type p ($T_p$), une grille et un drain du transistor à tension de polarisation de type p ($T_{pB}$) étant connectés à la grille et au drain du transistor de type p ($T_p$),
   - un module de contrôle de la tension de polarisation de type n ($CM_n$), comprenant un deuxième interrupteur ($SW_n$) et un transistor de tension de polarisation de type n ($T_{nB}$), le deuxième interrupteur ($SW_n$) se trouvant entre une borne de source du transistor de tension de polarisation de type n ($T_{nB}$) et une borne de source du transistor de type n ($T_n$), une grille et un drain du transistor à tension de polarisation de type n ($T_{nB}$) étant connectés à une grille et un drain du transistor de type n ($T_n$),
   - un module de commande LNA configuré pour commander le premier commutateur ($SW_p$) et le second commutateur ($SW_n$) de manière à faire fonctionner l'étage à source commune à réutilisation de courant sous une densité de courant constante, afin d'obtenir une linéarité constante.

9. La partie frontale de la revendication 8, dans lequel le LNA comprend au moins deux modules de contrôle de tension de polarisation de type p ($CM_p$) et/ou au moins deux modules de contrôle de tension de polarisation de type n ($CM_n$).

10. La partie frontale de l'une des revendications 8 à 9, dans lequel l'étage de source commune à réutilisation de courant comprend un module de contrôle de gain (GCM), dans lequel le module de contrôle de gain (GCM) comprend au moins une résistance de contrôle de gain ($R_{GCM}$) en série avec un troisième commutateur ($SW_{GCM}$), la série de la résistance de contrôle de gain ($R_{GCM}$) avec le troisième commutateur ($SW_{GCM}$) étant en parallèle avec la résistance de gain ($R_G$).

11. La partie frontale de l'une des revendications 8 à 10, dans lequel le transistor de type p ($T_p$) et le transistor de type n ($T_n$) fonctionnent en inversion modérée, de manière à optimiser un IIP3 du LNA.

12. La partie frontale de l'une des revendications 8 à 11, comprenant un amplificateur bande de base ou IF (30), connecté à une sortie du circuit électrique (20) et configuré de manière à fournir un gain bande de base ou IF dépendant du gain LNA et du gain du circuit électrique.

13. La partie frontale de la revendication 12, l'amplificateur bande de base ou IF étant un filtre bande de base ou IF.

**14.** La partie frontale de la revendication 13, dans lequel le filtre bande de base ou IF (30) est configuré comme un filtre bipolaire, comme un filtre unipolaire ou peut être contourné, de manière à échanger sa netteté contre la dissipation de puissance et/ou dans lequel le filtre bande de base ou IF est un filtre bande de base ou IF de premier étage (30'), le frontal comprenant un filtre bande de base ou IF de deuxième étage (30") en série avec le filtre bande de base ou IF de premier étage (30').

Fig. 1

EP 4 391 369 B1

Fig. 2

Differential gain from harmonic n to Baseband

Fig. 3

Fig. 4

Fig. 5

Fig. 6

Fig. 7

Fig. 8

Fig. 9

Fig. 10

Fig. 11

10

Fig. 12

wi: weak inversion
mi: moderate inversion
si-vs: strong inversion – velocity saturation

Fig. 13

Fig. 14

Fig. 15

Two pole filter

$$\frac{v_o}{v_i} = \frac{G w_o^2}{s^2 + \frac{w_o}{Q}s + w_o^2}$$

**Fig. 17A**

Single pole filter

$$\frac{v_o}{v_i} = \frac{G\, w_o}{s + w_o}$$

**Fig. 17B**

$S_0$ open
$S_2$ closed
$S_1$ open

$S_0$ open
$S_1$ closed
$S_2$ open

30

Filter Stage

**Fig. 16**

Stage 1

Stage 2

in →

| 1$^{st}$-order,<br>2$^{nd}$-order,<br>bypass |
|---|

→

| 1$^{st}$-order,<br>2$^{nd}$-order,<br>bypass |
|---|

out →

30'

30"

Fig. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10181868 B2

**Non-patent literature cited in the description**

- **CHEN HONGPENG**. A Wideband Dual-path Reconfigurable Receiver Front-end in 180 nm CMOS. *IEEE INTERNATIONAL CONFERENCE ON SEMICONDUCTOR ELECTRONICS (ICSE)*, 28 July 2020, 69-72

- **HAIWEI ZHANG et al.** Direct conversion receiver with high conversion gain and wide tuning range in 0.18 um CMOS. *ASIA-PACIFIC MICROWAVE CONFERENCE, (IEICE)*, 04 November 2014, 1037-1039